# EUROPÄISCHE PATENTANMELDUNG

(11) **EP 1 148 546 A1**
(43) Veröffentlichungstag der Anmeldung: **24.10.2001**
(21) Anmeldenummer: 00108561.2
(22) Anmeldetag: 19.04.2000
(51) Int. Cl.: H01L 21/98, H01L 25/04

(54) **Verfahren zur Justierung von Strukturen auf einem Halbleiter-substrat**

(71) Anmelder: Infineon Technologies AG, 81541 München (DE)
(72) Erfinder: Hübner, Holger, Dr., 85598 Baldham (DE)
(74) Vertreter: Hermann, Uwe, Dipl.-Ing.

(57) **Zusammenfassung**

Bei der dreidimensionalen Integration von integrierten Schaltungen wird ein gedünntes Halbleitersubstrat (1) auf einem zweiten Halbleitersubstrat angeordnet und mit diesem mechanisch und elektrisch verbunden. Dazu werden in dem zweiten, gedünnten Halbleitersubstrat (1) durchgehende Kontaktlöcher (24) ausgehend von einer Substratrückseite (3) bis zu einer ersten Metallverdrahtungsebene (22) auf einer Substratvorderseite (12) gebildet. Um die Kontaktlöcher (24), auf die auf der Vorderseite (2) angeordneten Strukturen zu justieren, wird eine Struktur (4) auf der Vorderseite (2) des Substrats (1) angeordnet, die auf der Vorderseite (2) als Justiermarke (7) verwendet werden kann. Die Struktur (4) wird mit einer Nutzschicht (15) überwachsen und ausgehend von der Rückseite (3) des Substrats (1) freigelegt, so daß die Struktur (4) auch von der Rückseite (3) als Justiermarke (7) verwendet werden kann. Dadurch wird ein Justagefehler zwischen den auf der Vorderseite (2) und der Rückseite (3) angeordneten Strukturen vermieden.

## Beschreibung

Die vorliegende Erfindung betrifft ein Verfahren zur Justierung von Strukturen auf einer Substratvorderseite und einer Substratrückseite.

Bei der dreidimensionalen Integration von integrierten Schaltungen wird ein gedünntes Halbleitersubstrat auf einem zweiten Halbleitersubstrat angeordnet und mit diesem mechanisch und elektrisch verbunden. Dieses Verfahren wird beispielsweise in "Vertically Integrated Circuits - A Key Technology for Future High Performance Systems", M. Engelhardt et. al. aus CIP '97 Proceedings, Proc. 11th International Colloquium on Plasma Processes, p. 187 (1997), Supplément à la Revue Le Vide: science, technique et applications; No 284, Avril-Mai-Juin 1997, Editor: Société Francaise du Vide, 19 rue du Renard, 75004 Paris, France, auf den Seiten 187 bis 192, beschrieben. Bei dem Verfahren ist die Justierung und Kontaktierung des Halbleitersubstrats einer der technologisch anspruchsvollsten und schwierigsten Prozeßschritte.

Für die dreidimensionale Integration werden üblicherweise zunächst zwei Wafer mit bereits prozessierten Schaltungsteilen bereitgestellt. Der erste Wafer dient dabei als Träger, der zweite Wafer wird mit dem folgenden Verfahren gedünnt und auf dem ersten Wafer angeordnet. Zur Dünnung wird zunächst der zweite Wafer auf seiner Vorderseite, bei der es sich um die Seite mit den elektrischen Schaltkreisen handelt, mit einer Klebeschicht versehen und mit einem Montageträger verbunden. Der zweite Wafer wird anschließend von seiner Rückseite her gedünnt. Zusätzlich werden von seiner Rückseite her Kontaktlochöffnungen durch das gedünnte Substrat bis zu der ersten Metallebene auf der Vorderseite des gedünnten Wafers gebildet. Die Justage der Kontaktlöcher bezüglich der Kontakte auf der Vorderseite des gedünnten Substrats kann nicht über die Vorderseite des gedünnten Substrats erfolgen, da dieses von dem Montageträger verdeckt ist.

Herkömmlicherweise wird der zweite Wafer daher auf seiner Rückseite mit einer Kontaktlithographie belichtet, wobei die Justage mit Hilfe einer Infrarotbelichtung auf Marken erfolgt, die auf der Vorderseite des gedünnten Wafers angeordnet sind. Dabei verursacht die Kontaktbelichtung, und besonders die infrarote Kontaktbelichtung, einen großen Justagefehler von typischerweise +/- 5 *µ*m. Üblicherweise werden daher die Kontaktbereiche auf der Vorderseite des gedünnten Substrats sehr groß ausgelegt. Dies bedeutet, daß wertvoller Platz auf der Vorderseite des Substrats, der zum Beispiel die elektrischen Schaltkreise enthält, von den großen Kontakten belegt wird.

Es ist die Aufgabe der Erfindung, ein Verfahren zur Justierung von Strukturen auf einer Substratvorderseite und einer Substratrückseite anzugeben, das einen wesentlich kleineren Justagefehler ermöglicht.

Erfindungsgemäß wird die Aufgabe durch ein Verfahren zur Justierung von Strukturen auf einer Substratvorderseite und einer Substratrückseite gelöst mit den Schritten:
- Bilden einer Struktur auf einer Vorderseite eines Substrats;
- Überwachsen der Struktur mit einer Nutzschicht;
- freilegen der Struktur, ausgehend von einer Rückseite des Substrats, die der Vorderseite des Substrats gegenüberliegt.

Das erfindungsgemäße Verfahren bildet zunächst eine Struktur auf der Vorderseite des Substrats. Nachfolgend können zum Beispiel weitere Schichten auf der Vorderseite des Substrats gebildet werden. In den weiteren Schichten werden z.B. elektrische Bauelemente und Schaltungen gebildet. Dabei kann die Struktur auf der Substratvorderseite für die Justierung in einem Stepper, der die Belichtung eines Fotolacks auf der Substratvorderseite durchführt, verwendet werden. Beispielsweise wird durch Ätzen der Rückseite des Substrats die Struktur, die für die Strukturierung der Substratvorderseite verwendet wird, auf der Substratrückseite freigelegt, so daß sie auch auf der Substratrückseite als Justiermarke für einen Stepper verwendet werden kann, um Fotolack auf der Substratrückseite für die Prozessierung der Substratrückseite zu belichten. Da die Struktur dazu geeignet ist, von einem Stepper verwendet zu werden, ist eine Kontaktbelichtung, die einen hohen Justagefehler aufweist, nicht mehr notwendig. Ebenso kann auf die Infrarotbelichtung durch den gedünnten Wafer hindurch verzichtet werden, was ebenfalls den Justagefehler senkt.

Ein Verfahrensschritt sieht vor, daß ein Justierschritt die auf der Rückseite freigelegte Struktur als Justiermarke verwendet. Dies ermöglicht in vorteilhafter Weise die Verwendung einer Stepperbelichtung anstelle einer Infrarot-Kontaktbelichtung, wodurch der Justagefehler wesentlich gesenkt werden kann.

Ein weiterer Verfahrensschritt sieht vor, daß ein Justierschritt die Struktur auf der Vorderseite des Substrats als Justiermarke verwendet. Der Vorteil dieses Verfahrensschritts liegt darin, daß sowohl die auf der Substratvorderseite als auch die auf der Substratrückseite gebildeten Strukturen auf die gleiche Struktur justiert werden können. Dadurch kann eine Dejustierung zwischen den auf der Substratvorderseite und den auf der Substratrückseite durchgeführten Prozeß- und Belichtungsschritten vermieden werden.

Ein weiterer Verfahrensschritt sieht vor, daß eine Ätzung der Rückseite die Struktur als Ätzmaske verwendet. Die Verwendung der Struktur als Ätzmaske ermöglicht es in vorteilhafter Weise, einen selbstjustierten Ätzprozeß auf der - Substratrückseite durchzuführen.

Eine Verfahrensvariante sieht vor, daß die Struktur als ein Graben in der Vorderseite des Substrats gebildet wird. Der Vorteil dieser Ausgestaltung besteht darin, daß ein Graben in einer Substratoberfläche als Justiermarke von einem Stepper verwendet werden kann.

Eine weitere Verfahrensvariante sieht vor, daß die Struktur als eine Erhebung auf der Vorderseite des Substrats gebildet wird. Eine Erhebung auf der Substratvorderseite ist dazu geeignet, als Justiermarke für einen Stepper zu dienen. Die Erhebung kann dabei aus dem gleichen Material wie das Substrat oder aber aus einem anderen Material gebildet werden.

Ist die Struktur aus einem anderen Material als das Substrat gebildet, so kann das andere Material in der Substratvorderseite eingesenkt sein und die Substratoberfläche planarisiert sein.

Weiterhin ist vorgesehen, daß eine dotierte Schicht in dem Substrat gebildet wird. Die dotierte Schicht hat dabei die Aufgabe, als Ätzstopp bei der Ätzung der Substratrückseite zu dienen. Die dotierte Schicht wird vorteilhafterweise so gebildet, daß sie die topographische Kontur der Struktur erhält. Dadurch ist es möglich, daß sowohl die Prozessierung auf der Substratvorderseite als auch die Prozessierung auf der Substratrückseite auf die gleiche Struktur justiert wird.

Weiterhin ist vorgesehen, daß die Rückseite des Substrats chemisch geätzt wird, wobei das Substrat gedünnt wird, die dotierte Schicht als Ätzstopp verwendet wird und die Struktur auf der Rückseite herausgebildet wird.

Eine weitere Verfahrensvariante sieht vor, daß neben der auf der Rückseite freigelegten Struktur ein zweiter Graben gebildet wird, der mit einem Maskenmaterial gefüllt wird. Der Vorteil dieses Verfahrensschrittes besteht darin, daß ein Maskenmaterial ohne zusätzliche photolithographische Belichtungsschritte, selbstjustiert zu der auf der Rückseite herausgebildeten Struktur, angeordnet werden kann. Das Maskenmaterial ist in einem nachfolgenden Ätzschritt als Ätzmaske verwendbar.

In einem weiteren Verfahrensschritt ist vorgesehen, daß der zweite Graben mit dem Maskenmaterial gefüllt wird, indem das Maskenmaterial auf der Rückseite des Substrats abgeschieden und planarisiert wird. Dieser Verfahrensschritt hat den Vorteil, daß das Maskenmaterial in den zweiten Graben eingebracht wird und eine selbstjustierte Ätzmaske bildet, ohne einen zusätzlichen lithographischen Belichtungsschritt zu erfordern.

Ein weiterer Verfahrensschritt sieht vor, daß das Maskenmaterial als eine Ätzmaske bei der Strukturierung der Rückseite verwendet wird. Durch diesen Prozeßschritt ist es möglich, beispielsweise Kontaktlöcher von der Substratrückseite zu der Substratvorderseite zu ätzen, die dort auf entsprechende Kontaktflächen justiert sind.

Es ist vorgesehen, daß die Struktur aus einem Maskenmaterial gebildet wird und als Ätzmaske zum Strukturieren der Rückseite verwendet wird, wobei neben der Struktur ein dritter Graben gebildet wird. Bei diesem Verfahrensschritt wird die Struktur auf der Vorderseite des Substrats aus einem Maskenmaterial gebildet. Die Struktur und dementsprechend das Maskenmaterial wird bei dem Ätzen der Substratrückseite freigelegt. In einem weiteren Substratrückseiten-Ätzschritt wird nun die Struktur als Ätzmaske verwendet, wobei neben der Struktur ein Graben gebildet wird. Der Vorteil dieses Vorgehens besteht darin, daß ein nachfolgender lithographischer Schritt auf der Substratrückseite auf die Struktur justiert werden kann.

Ein weiterer Verfahrensschritt sieht vor, daß der dritte Graben mit einem zweiten Maskenmaterial gefüllt wird und die Struktur von der Rückseite entfernt wird. Der Vorteil dieses Verfahrensschritts besteht darin, daß eine zweite Maske neben der Struktur gebildet wird. Die zweite Maske kann nun in einem nachfolgenden Ätzschritt als Ätzmaske verwendet werden, um den Bereich der Substratrückseite, der ehemals von der Struktur eingenommen wurde, zum Beispiel als Kontaktloch bis zu der Vorderseite des Substrats zu ätzen.

Eine weitere vorteilhafte Ausgestaltung des erfindungsgemäßen Verfahrens sieht vor, daß der dritte Graben mit einem zweiten Maskenmaterial gefüllt wird und die Struktur auf der Rückseite entfernt wird. Dieses Vorgehen hat den Vorteil, daß die ursprünglich von der Struktur belegte Rückseite durch einen Ätzprozeß strukturiert werden kann, um zum Beispiel ein Kontaktloch zu der Vorderseite des Substrats zu bilden.

Darüber hinaus ist vorgesehen, daß das zweite Maskenmaterial in dem dritten Graben als Ätzmaske bei dem Strukturieren der Rückseite verwendet wird. Durch die Verwendung des zweiten Maskenmaterials als Ätzmaske ist ebenfalls ein zu der Struktur selbstjustierter Ätzprozeß möglich, da der dritte Graben und damit das zweite Maskenmaterial selbstjustiert zu der Struktur gebildet wurde.

Ein weiterer Verfahrensschritt sieht vor, daß die dotierte Schicht auf der Vorderseite des Substrats aufgewachsen wird. Das Aufwachsen der dotierten Schicht hat den Vorteil, daß die Struktur auf der Vorderseite des Substrats konform mit der dotierten Schicht umhüllt wird, so daß die dotierte Schicht eine Topographie aufweist, die der Struktur entspricht.

Eine weitere Verfahrensvariante sieht vor, daß die erste dotierte Schicht durch Implantation von Dotierstoff in dem Substrat gebildet wird. Die Implantation von Dotierstoff hat den Vorteil, daß die dotierte Schicht konform zu der Struktur eingebracht werden kann.

Eine weitere Verfahrensvariante sieht vor, daß auf die dotierte Schicht eine Nutzschicht aufgewachsen wird. Die Nutzschicht kann zum Beispiel für die Bildung von Schaltungen oder Strukturen verwendet werden.

Weiterhin ist vorgesehen, daß auf der Vorderseite des Substrats eine Schaltung gebildet wird.

Eine Verfahrensvariante sieht vor, daß die Nutzschicht auf die Vorderseite des Substrats aufgewachsen wird, wobei die Nutzschicht auf der Struktur mit einer unterschiedlichen Wachstumsrate oder Morphologie aufgewachsen wird, als auf einer Substratoberfläche. Der Vorteil dieses Vorgehens liegt darin, daß sich eine als Erhebung ausgebildete Struktur auf der Oberseite der Nutzschicht als Vertiefung ausbildet.

Ein weiterer Verfahrensschritt sieht vor, daß die Struktur von der Vorderseite des Substrats entfernt wird, wodurch die dotierte Schicht strukturiert wird. Wird die Struktur beispielsweise als Erhebung ausgebildet und anschließend die dotierte Schicht gebildet, so kann durch Entfernen der Erhebung die dotierte Schicht in dem Bereich der Erhebung mit entfernt werden. Dadurch ist es zum Beispiel möglich, ein Fenster in der dotierten Schicht zu bilden.

Eine weitere Verfahrensvariante sieht vor, daß die Rückseite des Substrats geätzt wird und die strukturierte dotierte Schicht als Ätzstopp verwendet wird, wobei in einem Bereich, in dem die dotierte Schicht ein Maskenfenster aufweist, ein vierter Graben in der Rückseite des Substrats gebildet wird. Der Vorteil dieser Verfahrensvariante besteht darin, daß die strukturierte dotierte Schicht ein Maskenfenster aufweist, in dem mit einem geeigneten Ätzschritt ein Graben gebildet werden kann.

Weitere vorteilhafte Ausgestaltungen der Erfindung sind in den abhängigen Ansprüchen angegeben.

Nachfolgend wird die Erfindung anhand von Ausführungsbeispielen und Figuren näher erläutert.

In den Figuren zeigen:
- Figur 1: ein gedünntes Substrat mit einem Kontaktloch, das von der Substratrückseite zu der ersten Metallisierungsebene reicht;
- Figur 2: ein Substrat mit einer Struktur;
- Figur 3: das gedünnte Substrat aus Figur 2;
- Figur 4: eine weitere Ausgestaltung des Substrats aus Figur 3;
- Figur 5: eine weitere Verfahrensvariante, wobei die Struktur als Erhebung ausgebildet ist;
- Figur 5a: eine Verfahrensvariante nach Figur 5, jedoch ohne die optionale dotierte Schicht;
- Figur 6, 7 und 8: weiterführende Prozeßschritte, die mit der in Figur 5 bzw. 5a dargestellten Struktur durchgeführt werden.

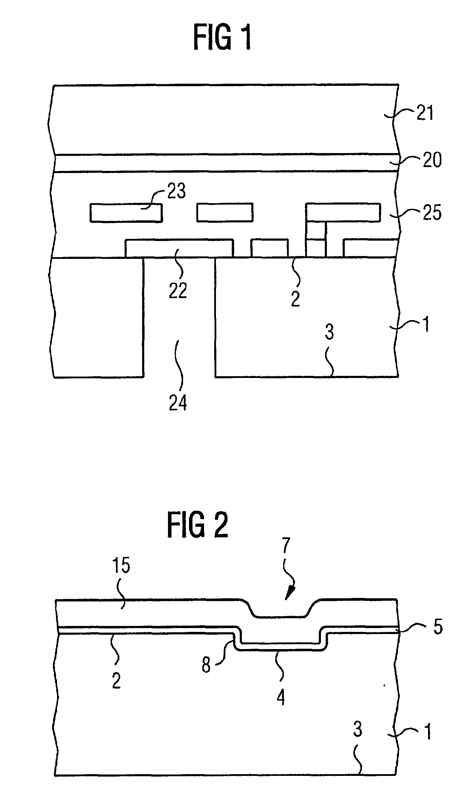

In Figur 1 ist ein gedünntes Substrat 1 dargestellt, auf dem eine Isolationsschicht 25 angeordnet ist, in der sich beispielsweise eine erste Metallebene 22 und eine zweite Metallebene 23 befindet. Weiterhin ist ein Kontaktloch 24 von einer Rückseite 3 des Substrats 1 bis zu einer Vorderseite 2 des Substrats 1 gebildet, wobei die erste Metallisierungsebene 22 von der Rückseite her in einem Kontaktbereich freigelegt ist.

Die Isolationsschicht 25 ist mittels einer Klebeschicht 20 an einem Montageträger 21 befestigt. Die Befestigung des Substrats 1 an dem Montageträger 21 dient dazu, das Substrat 1 von der Rückseite 3 her dünnen zu können, bevor das Kontaktloch 24 gebildet wird.

Mit Hilfe der Figuren 2 bis 4 wird ein Herstellungsverfahren für eine Justiermarke 7 beschrieben, die sowohl ausgehend von der Substratvorderseite 2 als auch von der Substratrückseite 3 zur Justierung von Strukturen auf dem Substrat 1 mittels lithographischer Prozesse verwendet werden kann.

In Figur 2 ist ein ungedünntes Substrat 1 dargestellt, das eine Vorderseite 2 und eine Rückseite 3 aufweist. In der Vorderseite 2 des Substrats 1 ist eine Struktur 4 als ein Graben 8 eingebracht. Die Struktur 4 kann von der Vorderseite als Justiermarke 7 verwendet werden. Auf der Vorderseite 2 des Substrats 1 und in dem Graben 8 ist eine dotierte Schicht 5 angeordnet. Auf der dotierten Schicht 5 befindet sich eine Nutzschicht 15. In diesem Ausführungsbeispiel ist das Substrat 1 aus Silizium gebildet. Die Struktur 4 wird durch einen Stepper-Belichtungsschritt mit anschließender Grabenätzung gebildet. Die dotierte Schicht 5 wird zum Beispiel durch ein epitaktisches Aufwachsverfahren gebildet. Auf die dotierte Schicht 5 wird die Nutzschicht 15 aufgewachsen, die ebenfalls durch ein epitaktisches Aufwachsverfahren gebildet werden kann. Beispielsweise kann auf der Nutzschicht 15 eine Schaltungsanordnung in CMOS-Technologie gebildet werden. Bei dem Aufwachsen der Nutzschicht 15 handelt es sich beispielsweise um einen konformen Abscheideprozeß, so daß die Struktur 4 in die Nutzschicht 15 übertragen wird und somit als Justiermarke 7 für einen Stepper verwendbar ist.

Eine weitere Verfahrensvariante, die geeignet ist, die in Figur 2 dargestellte Struktur herzustellen, ätzt zunächst einen Graben 8 in die Vorderseite 2 des Substrats 1 und bringt die dotierte Schicht 5 mittels einer Implantation in das Substrat 1 ein. Auch bei diesem Herstellungsverfahren wird die dotierte Schicht 5 als vergrabene Schicht gebildet, so daß oberhalb der dotierten Schicht 5 eine Nutzschicht 15 mit einer von der dotierten Schicht 5 abweichenden Dotierung angeordnet ist.

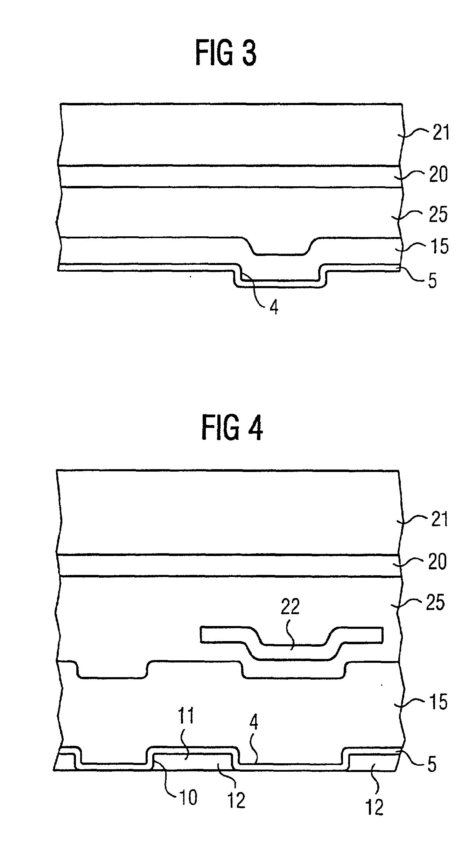

Mit Bezug auf Figur 3 ist auf der Nutzschicht 15, in der beispielsweise Feldeffekttransistoren angeordnet sind, eine Isolationsschicht 25, in der beispielsweise eine Metallverdrahtung für die Feldeffekttransistoren angeordnet ist. Mittels einer Klebeschicht 20 ist die Isolationsschicht 25 an einem Montageträger 21 befestigt. Das Substrat 1 wird von seiner Rückseite 3 her abgeschliffen und naßchemisch geätzt, wobei die Ätzung selektiv auf der dotierten Schicht 5 stoppt. Da die dotierte Schicht 5 als Ätzstopp wirkt, bildet sich die Struktur 4 auf der Rückseite 3 des Substrats 1 heraus. Die Struktur 4 kann auf der Rückseite 3 in einem fotolithographischen Prozeß von einem Stepper als Justiermarke verwendet werden. Dadurch ist es möglich, ein Kontaktloch relativ zu der Justiermarke 7 mit einer hohen Präzision, die nicht von einem Infrarotkontaktbelichter erreicht wird, zu positionieren.

Mit Bezug auf Figur 4 ist zusätzlich ein selbstjustierter Prozeß möglich, mit dessen Hilfe ein Kontaktloch selbstjustiert, ohne weitere lithographische Strukturierung, von der Rückseite 3 des Substrats 1 zu der ersten Metallebene 22 gebildet werden kann. In Figur 4 ist die Nutzschicht 15 dargestellt, auf der sich eine Isolationsschicht 25 befindet, in der beispielsweise die erste Metallebene 22 angeordnet ist. Um die Rückseite 3 abschleifen und ätzen zu können, ist diese Anordnung mittels einer Klebeschicht 20 an einem Montageträger 21 befestigt. Weiterhin ist die dotierte Schicht 5 auf der Rückseite der Nutzschicht 15 angeordnet. Durch den Rückseitenätzprozeß ist die Rückseite 3 bis zu der dotierten Schicht 5 entfernt. Durch das Ätzen der Rückseite 3 des Substrats 1 wird neben der Struktur 4 ein zweiter Graben 10 gebildet, der mit einem Maskenmaterial 11 aufgefüllt wird, das als Ätzmaske 12 verwendet wird. Das Auffüllen kann beispielsweise durch eine ganzflächige Abscheidung von Siliziumdioxid mit anschließendem Planarisieren mittels eines CMP (Chemical Mechanical Polishing) Prozeßschritts durchgeführt werden. Mögliche Abscheideverfahren für Siliziumoxid sind CVD (Chemical Vapor Deposition) Verfahren. Die Ätzmaske 12 kann nun dazu verwendet werden, als Maske für die Ätzung der freiliegenden dotierten Schicht 5 und der darüberliegenden Nutzschicht 15 zu dienen, wobei ein Kontaktloch von der Rückseite 3 bis zu der ersten Metallebene 22 geätzt werden kann.

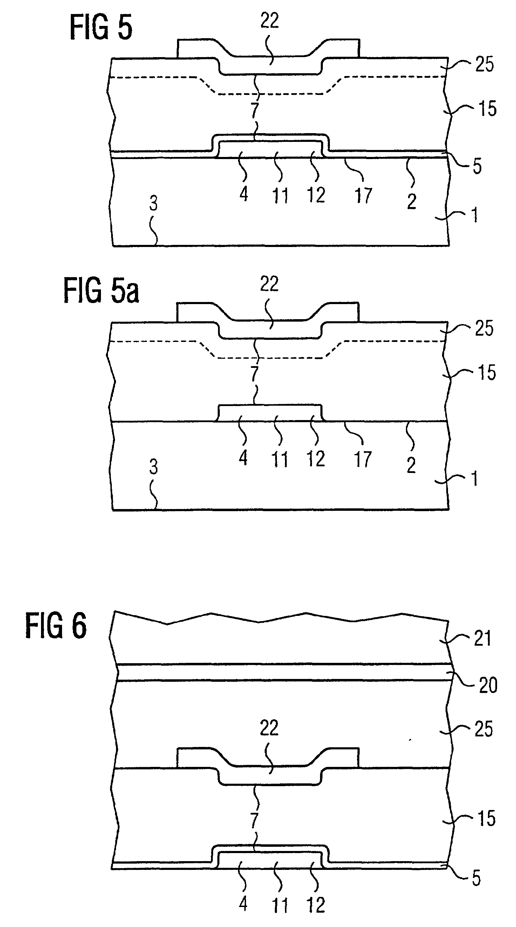

Mit Bezug auf die Figuren 5 bis 8 wird ein weiteres Herstellungsverfahren einer Struktur 4 beschrieben, die als Justiermarke verwendet werden kann. In Figur 5 ist ein Substrat 1 mit einer Substratvorderseite 2 und einer Substratrückseite 3 dargestellt. Auf der Vorderseite 2 des Substrats 1 wird eine Struktur 4 als Erhebung aus einem Maskenmaterial 11 gebildet. Die Struktur 4 dient in einem Belichtungsschritt mit einem Stepper als Justiermarke 7. Auf der Vorderseite 2 des Substrats 1 ist eine dotierte Schicht 5 angeordnet. Die dotierte Schicht 5 ist in diesem Ausführungsbeispiel konform auf der Substratoberfläche 17 und der Struktur 4 angeordnet. Die dotierte Schicht 5 ist optional und kann weggelassen werden, was in Figur 5a dargestellt ist. Auf der dotierten Schicht 5 ist eine Nutzschicht 15 angeordnet, auf der sich eine Isolationsschicht 25 befindet. Oberhalb der Isolationsschicht 25 ist eine erste Metallebene 22 angeordnet. Zur Herstellung der in Figur 5 dargestellten Struktur wird beispielsweise ein Substrat 1 aus Silizium bereitgestellt. Auf die Substratoberfläche 17 des Substrats 1 wird ganzflächig eine Schicht aus dem Maskenmaterial 11 abgeschieden und strukturiert, so daß die Justiermarke 7 auf der Substratoberfläche 17 gebildet wird.

Es ist ebenfalls möglich, die Justiermarke 7 als Struktur 4 zu gestalten, indem in die Substratoberfläche 17 ein Graben geätzt wird, der mit dem Maskenmaterial 11 gefüllt wird und anschließend auf die Höhe der Substratoberfläche 17 planarisiert wird. In diesem Fall ist die Justiermarke 7 in die Substratoberfläche 17 eingesenkt.

Anschließend kann mit einem Abscheideverfahren die dotierte Schicht 5 gebildet werden. Bei diesem Abscheideverfahren kann es sich beispielsweise um ein epitaktisches Abscheideverfahren oder eine Implantation handeln. Die Epitaxie setzt die Einkristallinität des Substrats 1 lediglich an der Substratoberfläche 17 fort und bildet auf der Justiermarke 7, die aus dem Maskenmaterial 11 gebildet ist, eine Polykristalline dotierte Schicht 5. Ebenfalls kann hier vorgesehen werden, daß die dotierte Schicht 5 lediglich auf der Substratoberfläche 17 und nicht auf dem Maskenmaterial 11 wächst, so daß eine selektive Epitaxie durchgeführt wird. Anschließend wird eine Nutzschicht 15 epitaktisch aufgewachsen. Auch hier setzt sich die Einkristallinität der Nutzschicht 15 oberhalb der Substratoberfläche 17 fort und das Wachstum oberhalb des Maskenmaterials 11 ist Polykristallin. Die Epitaxie kann so eingestellt werden, daß sie selektiv durchgeführt wird, wobei die Epitaxie oberhalb des Maskenmaterials 11 wesentlich langsamer wächst, so daß die Struktur 4 an der Oberfläche der Nutzschicht 15 als ein Graben ausgebildet wird, der als Justiermarke 7 verwendet werden kann.

Mit Bezug auf Figur 6 ist das Substrat an einem Montageträger 21 befestigt. Das Substrat 1 ist von seiner Rückseite 3 gedünnt worden, so daß durch den Ätzprozeß die Rückenseitenätzung auf der dotierten Schicht 5 selbstjustiert stoppt. Weiterhin stoppt die Rückenseitenätzung auch auf dem Maskenmaterial 11. Für den Fall, daß die optionale dotierte Schicht 5 nicht in dem Substrat 1 angeordnet ist, wird die Rückseite 3 des Substrats 1 beispielsweise durch zeitgesteuerte Schleifprozesse und zeitgesteuerte Ätzprozesse abgetragen, so daß bei erreichen der gewünschten Restdicke des Substrats 1 die Dünnung des Substrats 1 beendet wird.

Mit einem anschließenden reaktiven Ionenätzschritt, der das Silizium der dotierten Schicht 5 und der Nutzschicht 15 ätzt, kann die Struktur 4, die in diesem Fall aus Siliziumoxid gebildet ist, als Ätzmaske verwendet werden. Diese Ätzung kann ebenfalls naßchemisch erfolgen. Bei dem Ätzprozeß wird das Silizium, welches neben der Struktur 4 angeordnet ist, geätzt, so daß ein dritter Graben 13 entsteht. Anschließend wird eine konforme oder eine planarisierende Abscheidung durchgeführt, die ein zweites Maskenmaterial 14 auf der Rückseite 3 abscheidet. Bei dem Abscheidevorgang wird der dritte Graben 13 mit dem zweiten Maskenmaterial 14 gefüllt.

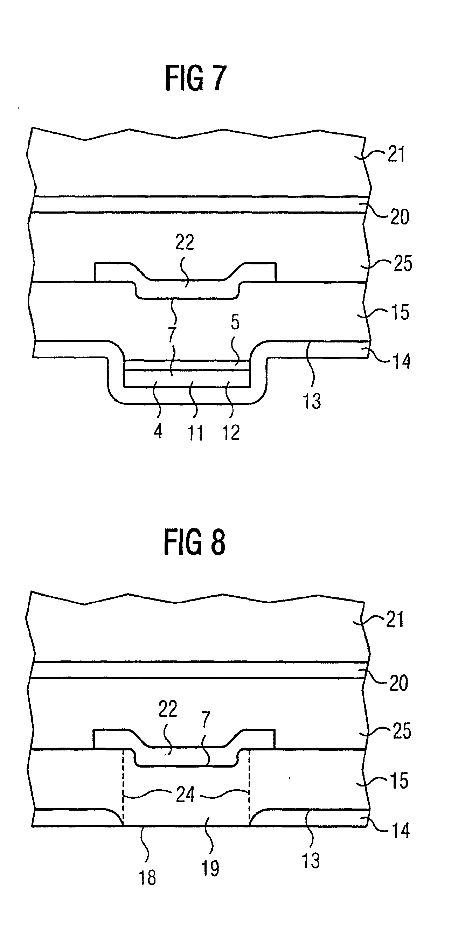

Mit Bezug auf Figur 8 wird anschließend ein Planarisierungsschritt durchgeführt, bei dem die Rückseite 3 planarisiert wird. Es wird das zweite Maskenmaterial 14, die Struktur 4 und die dotierte Schicht 5 entfernt und ein Bereich 18 freigelegt. In einem anschließenden Ätzprozeß wird das zweite Maskenmaterial 14, welches in dem dritten Graben 13 angeordnet ist, als Ätzmaske für die Ätzung der Nutzschicht 15 in dem freigelegten Bereich 18 verwendet. Dabei wird beispielsweise ein vierter Graben 19 geätzt, der als Kontaktloch 24 die erste Metallebene 22 freilegt.

Die dotierte Schicht 5 wird bei dem angegebenen Verfahren beispielsweise mit p-Dotierstoff gebildet, wozu Bor verwendet wird. Die Ätzmaske 12 und das zweite Maskenmaterial 14 kann beispielsweise aus Siliziumoxid oder Siliziumnitrid gebildet werden. Wird die Struktur 4 aus einem vom Substrat 1 verschiedenen Material gebildet, so kann für die Struktur 4 z.B. Siliziumoxid oder Siliziumnitrid oder Titannitrid verwendet werden.

Wird das Substrat 1 sehr stark gedünnt, so kann es sich aufgrund innerer Spannungen verziehen. In diesem Fall kann eine auf das gedünnte Substrat 1 justierte Photolithographie trotz der Justierung auf geeignete Justiermarken eine Dejustage zu den in dem Substrat 1 gebildeten Strukturen verursachen. Aus diesem Grund ist es besonders vorteilhaft, die Ätzung der Rückseite 3 des Substrats 1 selbstjustiert mit Hilfe von selbstjustierten Ätzmasken durchzuführen, damit die Strukturen an den geeigneten Positionen des Substrats 1 entstehen.

### Bezugszeichenliste

- 1: Substrat
- 2: Vorderseite des Substrats
- 3: Rückseite des Substrats
- 4: Struktur
- 5: Dotierte Schicht
- 7: Justiermarke
- 8: Graben
- 9: Erhebung
- 10: Zweiter Graben
- 11: Maskenmaterial
- 12: Ätzmaske
- 13: Dritter Graben
- 14: Zweites Maskenmaterial
- 15: Nutzschicht
- 16: Schaltung
- 17: Substratoberfläche
- 18: Bereich
- 19: Vierter Graben
- 20: Klebeschicht
- 21: Montageträger
- 22: Erste Metallebene
- 23: Zweite Metallebene
- 24: Kontaktloch
- 25: Isolationsschicht

## Patentansprüche

1. Verfahren zur Justierung von Strukturen auf einer Substratvorderseite und einer Substratrückseite mit den Schritten:
- Bilden einer Struktur (4) auf einer Vorderseite (2) eines Substrats (1);
- Überwachsen der Struktur (4) mit einer Nutzschicht (15);
- freilegen der Struktur (4), ausgehend von einer Rückseite (3) des Substrats (1), die der Vorderseite (2) des Substrats (1) gegenüberliegt.

2. Verfahren nach Anspruch 1,
**dadurch gekennzeichnet, daß**
ein Justierschritt die auf der Rückseite (3) freigelegte Struktur (4) als Justiermarke (7) verwendet.

3. Verfahren nach einem der Ansprüche 1 oder 2,
**dadurch gekennzeichnet, daß**
ein Justierschritt die Struktur (4) auf der Vorderseite (2) des Substrats (1) als Justiermarke verwendet.

4. Verfahren nach einem der Ansprüche 1 bis 3,
**dadurch gekennzeichnet, daß**
eine Ätzung der Rückseite (3) die Struktur (4) als Ätzmaske verwendet.

5. Verfahren nach einem der Ansprüche 1 bis 4,
**dadurch gekennzeichnet, daß**
die Struktur (4) als ein Graben (8) in der Vorderseite (2) des Substrats (1) gebildet wird.

6. Verfahren nach einem der Ansprüche 1 bis 5,
**dadurch gekennzeichnet, daß**
die Struktur (4) als eine Erhebung (9) auf der Vorderseite (2) des Substrats (1) gebildet wird.

7. Verfahren nach einem der Ansprüche 1 bis 6,
**dadurch gekennzeichnet, daß**
eine dotierte Schicht (5) in dem Substrat (1) gebildet wird.

8. Verfahren nach Anspruch 7,
**dadurch gekennzeichnet, daß**
die Rückseite (3) des Substrats (1) chemisch geätzt wird, wobei das Substrat (1) gedünnt wird, die dotierte Schicht (5) als Ätzstopp verwendet wird und die Struktur (4) auf der Rückseite (3) herausgebildet wird.

9. Verfahren nach einem der Ansprüche 1 bis 8,
**dadurch gekennzeichnet, daß**
neben der auf der Rückseite (3) freigelegten Struktur (4) ein zweiter Graben (10) gebildet wird, der mit einem Maskenmaterial (11) gefüllt wird.

10. Verfahren nach Anspruch 9,
**dadurch gekennzeichnet, daß**
der zweite Graben (10) mit dem Maskenmaterial (11) gefüllt wird, indem das Maskenmaterial (11) auf der Rückseite (3) des Substrats (1) abgeschieden und planarisiert wird.

11. Verfahren nach Anspruch 9 oder 10,
**dadurch gekennzeichnet, daß**
das Maskenmaterial (11) als eine Ätzmaske (12) bei der Strukturierung der Rückseite (3) verwendet wird.

12. Verfahren nach einem der Ansprüche 1 bis 11,
**dadurch gekennzeichnet, daß**
die Struktur (4) aus einem Maskenmaterial (11) gebildet wird und als Ätzmaske (12) zum Strukturieren der Rückseite (3) verwendet wird, wobei neben der Struktur (4) ein dritter Graben (13) gebildet wird.

13. Verfahren nach Anspruch 12,
**dadurch gekennzeichnet, daß**
der dritte Graben (13) mit einem zweiten Maskenmaterial (14) gefüllt wird und die Struktur (4) auf der Rückseite (3) entfernt wird.

14. Verfahren nach Anspruch 13,
**dadurch gekennzeichnet, daß**
das zweite Maskenmaterial (14) in dem dritten Graben (13) als Ätzmaske bei dem Strukturieren der Rückseite (3) verwendet wird.

15. Verfahren nach einem der Ansprüche 7 bis 14,
**dadurch gekennzeichnet, daß**
die dotierte Schicht (5) auf der Vorderseite (2) des Substrats (1) aufgewachsen wird.

16. Verfahren nach einem der Ansprüche 7 bis 15,
**dadurch gekennzeichnet, daß**
die dotierte Schicht (5) durch Implantation von Dotierstoff in dem Substrat (1) gebildet wird.

17. Verfahren nach einem der Ansprüche 7 bis 16,
**dadurch gekennzeichnet, daß**
auf die dotierte Schicht (5) eine Nutzschicht (15) aufgewachsen wird.

18. Verfahren nach einem der Ansprüche 1 bis 17,
**dadurch gekennzeichnet, daß**
auf der Vorderseite (2) des Substrats (1) eine Schaltung (16) gebildet wird.

19. Verfahren nach einem der Ansprüche 1 bis 18,
**dadurch gekennzeichnet, daß**
die Nutzschicht (15) auf die Vorderseite (2) des Substrats (1) aufgewachsen wird, wobei die Nutzschicht (15) auf der Struktur (4) mit einer unterschiedlichen Wachstumsrate oder Morphologie aufwächst, als auf einer Substratoberfläche (17).

20. Verfahren nach einem der Ansprüche 7 bis 19,
**dadurch gekennzeichnet, daß**
die Struktur (4) von der Vorderseite (2) des Substrats (1) entfernt wird, wodurch die dotierte Schicht (5) strukturiert wird.

21. Verfahren nach Anspruch 20,
**dadurch gekennzeichnet, daß**
die Rückseite (3) des Substrats (1) geätzt wird und die strukturierte dotierte Schicht (5) als Ätzstopp verwendet wird, wobei in einem Bereich (18), in dem die dotierte Schicht (5) ein Maskenfenster aufweist, ein vierter Graben (19) in der Rückseite (3) des Substrats (1) gebildet wird.
